# EUROPEAN PATENT SPECIFICATION

(11) **EP 1 233 085 B1**
(45) Date of publication and mention of the grant of the patent: **07.12.2005**
(21) Application number: 00956967.4
(22) Date of filing: 06.09.2000
(51) Int. Cl.: C30B 29/36, C30B 23/00, C30B 25/00, C30B 23/02, C30B 25/02, C30B 25/20, H01L 21/205

(54) **SiC SINGLE CRYSTAL AND METHOD FOR GROWING THE SAME**
SIC-EINKRISTALL UND HERSTELLUNGSVERFAHREN DAFÜR
MONOCRISTAL EN SiC ET SON PROCEDE DE CROISSANCE

(30) Priority: 06.09.1999 JP 25157599
(43) Date of publication of application: 21.08.2002
(73) Proprietor: Sixon Inc., Kyoto-shi, Kyoto 615-8686 (JP); THE KANSAI ELECTRIC POWER CO., INC., Osaka-shi, Osaka 530-8270 (JP); MITSUBISHI CORPORATION, Tokyo 100-8086 (JP); Sumitomo Electric Industries, Ltd., Osaka-shi, Osaka 541-0041 (JP)
(72) Inventor: SHIOMI, Hiromu, Suita-shi, Osaka 564-0004 (JP); KIMOTO, Tsunenobu, Fushimi-ku, Kyoto-shi, Kyoto 612-8031 (JP); MATSUNAMI, Hiroyuki, Yawata-shi, Kyoto 614-0000 (JP)
(74) Representative: HOFFMANN EITLE
(86) International application number: PCT/JP2000/006056
(87) International publication number: WO 2001/018287

(56) References cited:
- JP-A- 4 016 597
- JP-A- 5 262 599
- YOO W K ET AL: "SINGLE CRYSTAL GROWTH OF HEXAGONAL SIC ON CUBIC SIC BY INTENTIONAL POLYTYPE CONTROL" JOURNAL OF CRYSTAL GROWTH, NORTH-HOLLAND PUBLISHING CO. AMSTERDAM, NL, vol. 99, no. 1/4, PART 1, 1990, pages 278-283, XP000117437 ISSN: 0022-0248
- KIMOTO T ET AL: "Low temperature homoepitaxial growth of 6H-SiC by VPE method" SPRINGER PROCEEDINGS IN PHYSICS, vol. 71, 1992, pages 31-39, XP001120865 ISBN: 3-540-55687-7
- PATENT ABSTRACTS OF JAPAN vol. 1996, no. 02, 29 February 1996 (1996-02-29) & JP 07 267795 A (NIPPON STEEL CORP), 17 October 1995 (1995-10-17)
- J. YANG ET AL.: 'Sublimation growth of 6H-SiC crystals on different faces of a 6H-SiC seed' INST. PHYS. CONF. SER. vol. 137, 1994, pages 17 - 20, XP002934291

## Description

### TECHNICAL FIELD

The present invention relates to an SiC single crystal suitable for semiconductor electronic components and to a method for growing same, and more particularly relates to a 6H-poly-type SiC single crystal and a method for growing same.

### BACKGROUND ART

In recent years, compound semiconductors constituted using silicon carbide (SiC), gallium nitride (GaN) or other light chemical elements have been the subject of research. Compound semiconductors of this kind are characterized in that the bond energy required for a constitution using lightweight chemical elements is strong, and, as a result, the energy band gap, the electric field strength by which the insulation is destroyed, and the thermal conductivity are large. In addition, SiC in particular utilizes the characteristic of a wide band gap, and has attracted attention as a material for use in highly efficient, high voltage power devices, in high frequency power devices, high-temperature operation devices, or in devices emitting light ranging fromblue light to ultraviolet light. However, on account of a high bond energy, SiC compounds do not melt even at high temperatures under atmospheric pressure, meaning that it is problematic to cultivate a bulk crystal by means of re-crystallization by melting, as is employed using other semiconductors such as silicon (Si).

As an example of a method for growing a bulk-type SiC single crystal, theso-calledmodifiedLelyprocess is known, which is disclosed by the Japanese Patent Publication No. S59-48792 and the Japanese Patent Application Laid-open No. H2-30699. This modified Lely process involves placing a seed crystal composed from an SiC single crystal in a graphite crucible, and then sublimating raw material SiC powder under a reduced atmospheric pressure so as to re-crystallize an SiC single crystal of a target scale on the seed crystal.

The so-called sublimation method, which begins with the modified Lelyprocess, makes use of an SiC single crystal substrate, principally having an exposed plane {0001}, as the seed crystal. However, in a case where an SiC single crystal is grown using an SiC single crystal substrate whose plane direction is {0001}, since defects, which are known as micropipes and which extend in an axial direction <0001>, reach the surface of the single crystal, when an element is fabricated using this SiC single crystal, there have been cases where a leak current or the like has been generated.

As an example of a technology for resolving problems related to these micropipes, an SiC single crystal growth method is known, as disclosed, for example, by Patent Publication No. 2804860. This method is a method that uses an SiC single crystal, in which a crystal plane inclined by an angle α between 60° and 120° with respect to the plane {0001} is exposed, as a seed crystal, and, more preferably, is a method that uses an SiC single crystal, in which a plane {1-100} or {11-20} is exposed, as a seed crystal. By using a seed crystal of this kind, it is possible to reduce the occurrence of micropipes that reach the surface of the single crystal.

W. K.Yoo et al. ("Single crystal growth of hexagonal SiC on cubic SiC by intentional polytype control", Journal of crystal growth, North-Holland publishing Co., Amsterdam, NL, vol.99, no1/4, part 1, 1990, pages 278-283) discloses that crystal growth of SiC on 3C-SiC (100) substrates has been carried out by using a sublimation method utilizing the phase transformation from cubic 3C-SiC to hexagonal 6H-SiC at high temperatures. Further, it is stated that 6H-SiC with {0114} planes can be grown on 3C-SiC (100).

Kimoto T et al. ("Low temperature homoepitaxial growth of 6H-SiC by VPE method", Springer proceedings in physics, vol. 71, 1992, pages 31-39) discloses that crystal growth of SiC can be carried out at low temperatures of 1000-1500°C on two types of substrates, i.e. (i) 6H-SiC {0001} faces with 0-10° off-orientation towards [1120] and (ii) 6H-SiC {0114} substrates (without off-orientation).

JP 07/267795 relates to a method for growing a good quality SiC single crystal while suppressing the generation of crystal grains varying in crystal bearings from a seed crystal. As seed crystal substrate, one having a face inclined by an off angle in the {0001} C face direction from the {1100} face is used.

J.Yang et al. ("Sublimation growth of 6H-SiC crystals on different faces of a 6H-SiC seed", Inst. Phys. Conf. Ser., 137//00-00-1994, pages 17-20) is a scientific paper discussing the quality of 6H-SiC crystals grown by the sublimation method on the basal plane of SiC seed crystals as well as on different 6H-SiC substrate faces. The so-called {1104} plane, which makes an angle of 54.7° with respect to the {0001} plane, is said to be a good substrate orientation to grow micropipes-free 6H-SiC.

### DISCLOSURE OF THE INVENTION

However, the SiC single crystal growth method that appears in Patent Publication No. 2804860 exhibits the following problems. That is, when the inventors of the invention that appears in this publication used an SiC single crystal having an exposed plane {1-100} or {11-20} as a seed crystal, as described in "Physics Status Solid" (b) (No. 202, Pages 163-175, 1997), although it is possible to control crystal polymorphism, and to suppress the situation according to which micropipes reach the crystal surface, there has been the problem that high-density stacking faults are exposed at the surface of the SiC single crystal. These stacking faults spread in a planar fashion when a crystal is grown, and, when an element is fabricated using this SiC single crystal in which such stacking faults are exposed at the surface thereof, as per a case in which an SiC single crystal is used in which micropipes are exposed at the surface thereof, there is a risk that a leak current or the like will be generated.

The present invention was conceived in view of such conditions, it being an object thereof to provide an SiC single crystal inwhichmicropipes and stacking faults, which are exposed at the surface of the crystal, are reduced, and to provide a method for growing same.

The present invention is a method as defined in claim 1 for growing a 6H-poly-type SiC single crystal, characterized in that a 6H-poly-type SiC single crystal is grown on a seed crystal composed from an SiC single crystal in which a plane {01-14} or a plane inclined by an off angle α equal to or less than approximately 10° with respect to the plane {01-14} is exposed.

If the method for growing an SiC single crystal relating to the present invention uses a seed crystal in which a plane {01-14} is exposed, for example, the exposed plane of this seed crystal has an inclination of approximately 35° with respect to the direction <0001> in which the micropipes extend. For this reason, if a 6H-poly-type SiC single crystal is grown on a seed crystal of this kind, the micropipes reach a lateral face of this SiC single crystal, and it is therefore possible to suppress the situation where the micropipes reach the surface of the SiC single crystal. In addition, the exposed plane ({01-14}) of the seed crystal has an inclination of approximately 55°with respect to a plane over which the stacking faults spread, that is, a plane that is perpendicular to the direction <0001>, meaning that, if a 6H-poly-type SiC single crystal is grown on a seed crystal of this kind, the stacking faults reach a lateral face of this SiC single crystal, and it is therefore possible to suppress the situation where these stacking faults reach the surface of the SiC single crystal. Furthermore, even if the exposed plane of the seed crystal is not the plane {01-14}, but instead is a plane that is inclined by an off angle α equal to or less than approximately 10° with respect to the plane {01-14}, it is equally possible to suppress the situation where micropipes and stacking faults reach the surface of the SiC single crystal thus grown.

Further, it is preferable that the off angle α should be equal to or less than 5°, and more preferable that the off angle α should be equal to or less than 3°. In other words, the closer the surface of the seed crystal is to the plane {01-14}, the more feasible it becomes to reliably suppress the situation where micropipes and stacking faults reach the surface of the SiC single crystal.

Further, another method for growing an SiC single crystal, relating to the present invention, which sublimates SiC raw material powder in a graphite crucible so as to re-crystallize a 6H-poly-type SiC single crystal on a seed crystal which has been placed in a crucible, is characterized in that an SiC single crystal, in which a plane {01-14} or a plane inclined by an off angle α equal to or less than approximately 10° with respect to the plane {01-14} is exposed, is used as the seed crystal.

If, according to a method for growing an SiC single crystal of this kind, the exposed plane of the seed crystal, which is placed in a graphite crucible, is the plane {01-14}, for example, the exposed plane of this seed crystal has an inclination of approximately 35° with respect to the direction <0001> in which the micropipes extend. For this reason, if SiC raw material powder is sublimated so as to grow a 6H-poly-type SiC single crystal on a seed crystal of this kind, the micropipes reach a lateral face of this SiC single crystal, and it is therefore possible to suppress the situation where the micropipes reach the surface of the SiC single crystal. In addition, the exposed plane ({01-14}) of the seed crystal has an inclination of approximately 55°with respect to a plane over which the stacking faults spread, that is, a plane that is perpendicular to the direction <0001>, meaning that, if a 6H-poly-type SiC single crystal is grown on a seed crystal of this kind, the stacking faults reach a lateral face of this SiC single crystal, and it is therefore possible to suppress the situation where these stacking faults reach the surface of the SiC single crystal. Furthermore, even if the exposed plane of the seed crystal is not the plane {01-14}, but instead is a plane that is inclined by an off angle α equal to or less than approximately 10° with respect to the plane {01-14}, it is equally possible to suppress the situation where micropipes and stacking faults reach the surface of the SiC single crystal thus grown.

### BRIEF DESCRIPTION OF THE DRAWINGS

Fig. 1 is a cross-sectional view to show a crystal growing device for growing an SiC single crystal, according to the present invention;
Fig. 2 is a figure serving to illustrate the plane {01-14} of the SiC single crystal;
Fig. 3 is a figure to show the state of the micropipes and stacking faults within the SiC single crystal;
Fig. 4 is a figure to show a seed crystal whose surface is inclined by an off angle α with respect to the plane {01-14}.

### BEST MODE FOR CARRYING OUT THE INVENTION

Hereinbelow, by referring to the attached figures, the preferred embodiment for the SiC single crystal and method for growing same, relating to the present invention, will be described in detail. Further, like reference symbols have been employed for like constituent elements, and therefore a repeated description thereof will be omitted here. There are cases where the crystal lattice direction and lattice plane are employed in the course of a description of the embodiment and examples. However, here, a symbol description for lattice direction and lattice plane is provided. A direction of separation is represented by "[]", a direction of convergence is represented by "<>", a separate plane is represented by "()", and a convergent plane is represented by "{}", respectively. Further, with regard to negative indices, incrystallography, a"-" (bar) is provided as a superscript character. However, for the sake of the creation of a specification, a negative symbol is provided before a given character.

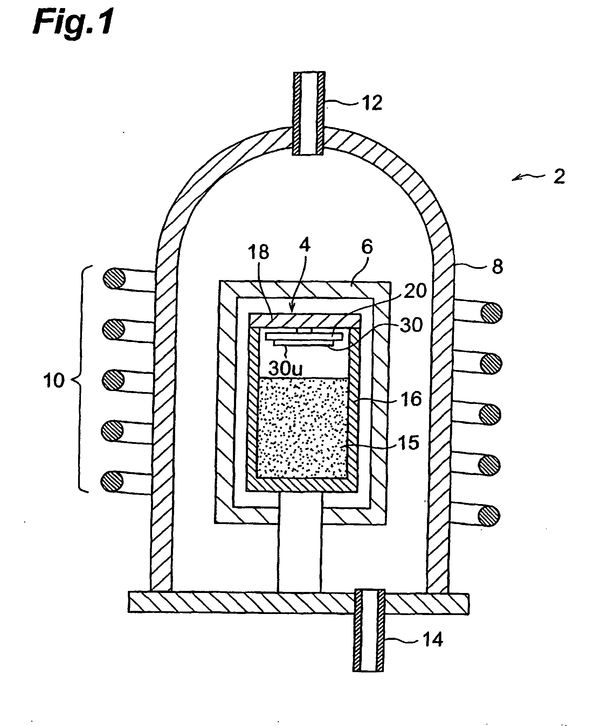

Fig. 1 is a cross-sectional view to show a crystal growing device 2 for growing an SiC single crystal, according to the present embodiment. The crystal growing device 2 is principally constituted from a graphite crucible 4 for growing an SiC single crystal therein; a heat shielding member 6, which prevents the radiation of heat from the graphite crucible 4 to the outside; a water-cooled reaction tube 8, which encircles the heat shielding member 6; and a high frequency coil 10, which is wound around the circumference of the reaction tube 8 and which heats the crucible 4. Further, a gas introduction tube 12, which is for the introduction of an inert gas such as argon gas, is inserted at the top of the reaction tube 8, and a gas extraction tube 14, which is for the extraction of inert gas to the outside, is inserted at the bottom of the reaction tube 8.

The crucible 4 is constituted from an accommodating portion 16, which is of a cylindrical shape with a bottom and which accommodates the raw material 15 composed from multiple SiC crystals; a cover portion 18, which seals off the upper opening of the accommodating portion 16; and a seed crystal placement portion 20, which is attached to the cover portion 18, and which has a seed crystal 30 fixed to the underside thereof. Here, in the present embodiment, an SiC single crystal is used as the seed crystal 30, which SiC single crystal is a 6H-poly-type SiC single crystal (signifies a crystal structure in which "H" denotes a hexagonal system and "6" signifies that atoms are stacked in 6 layers forming one cycle) in which a plane {01-14} is exposed.

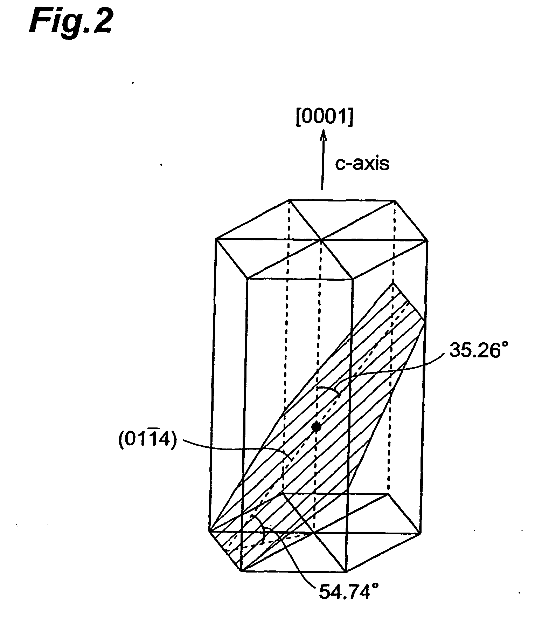

Next, by referring to Fig. 2, the plane (01-14) of the 6H - SiC single crystal will be described. As shown in the same figure, plane (01-14) has an inclination of approximately 35°(35.26°) with respect to the direction [0001], and an inclination of approximately 55° (54.74°) with respect to a plane that is perpendicular to the direction [0001].

Next, by referring to Figs. 1 to 4, a method for growing an SiC single crystal will be described.

A crucible 4 accommodating raw material 15 and a seed crystal 30 is placed inside a reaction tube 8, whereupon the reaction tube 8 is evacuated, to create a vacuum therein, for approximately one hour. Thereafter, an inert gas is introduced thereto by means of a gas introduction tube 12 to thereby create a normal pressure (760 Torr) inside the reaction tube 8. Then the reaction tube 8 is evacuated once again, to create a vacuum therein, for approximately ten minutes, and inert gas is introduced thereto by means of the gas introduction tube 12 to thereby create a normal pressure (760 Torr) inside the reaction tube 8 once again.

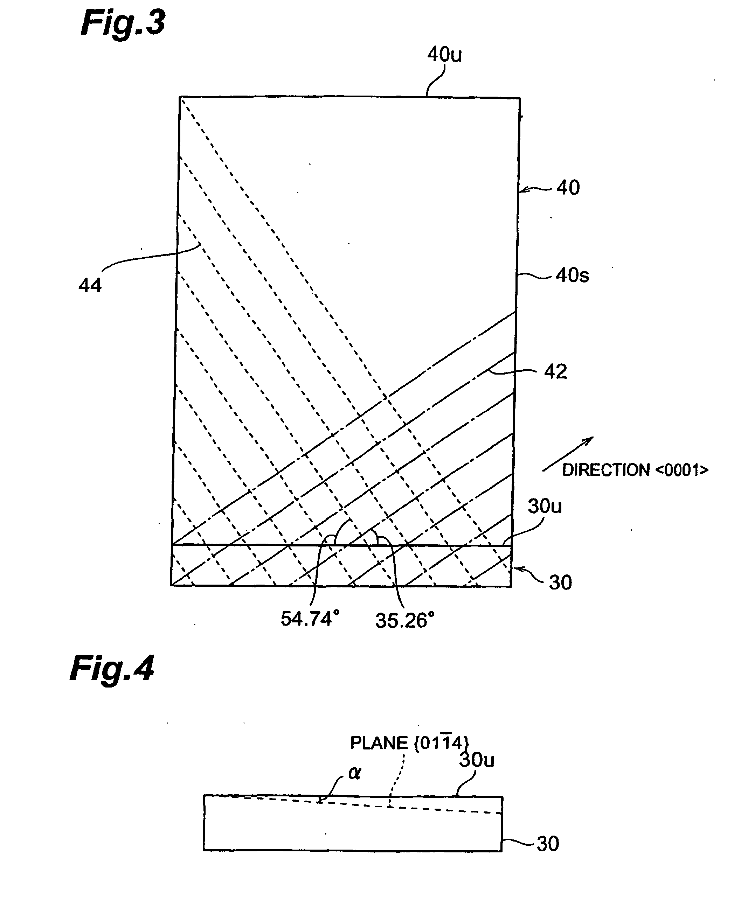

Once the above process is complete, heating of the crucible 4 commences by means of a high-frequency coil 10. Thereupon, the temperature of the crucible 4 is raised to 2000°C, and a temperature gradient is set such that the temperature of the seed crystal 30 is approximately 50°C lower than the temperature of the raw material 15. At the same time, the pressure force within the reaction tube 8 is lowered to approximately 4 Torr. In this manner, the raw material 15, which is composed from multiple SiC crystals, is sublimated, and the gas of the raw material 15 thus reaches the seed crystal 30, and, as shown in Fig. 3, it is thus possible to grow a 6H-poly-type SiC single crystal 40 with a diameter of approximately two inches on the surface (exposed plane) 30u of the seed crystal 30. Further, in Fig. 3, the SiC single crystal 40 is positioned vertically above the seed crystal 30 to aid comprehension of the invention. However, in actuality, as may be discerned from Fig. 1, the SiC single crystal 40 is grown vertically below the seed crystal 30.

Here, by referring to Fig. 3, the growth process for the SiC single crystal 40 will be described in detail. Ordinarily, when an SiC single crystal is grown, there are often contained, within the SiC single crystal, micropipes, which extend in the direction <0001>, and stacking faults that spread over a plane that is perpendicular to the direction <0001>. In addition, when an element is fabricated using this SiC single crystal at whose surface a multiplicity of micropipes and stacking faults are exposed, there has been a risk of a leak current or the like being generated.

Here, when a seed crystal 30, in which a plane {01-14} is exposed, as shown in the present embodiment, is used, the surface 30u of the seed crystal 30, as described hereinabove, has an inclination of approximately 35° with respect to the direction <0001> in which the micropipes 42 (shown by dot-chain lines in the figure) extend. For this reason, if an SiC single crystal 40 is grown to a given extent on the seed crystal 30, the micropipes 42 reach a lateral face 40s of this SiC single crystal 40, and it is therefore possible to suppress the situation where the micropipes 42 reach the surface 40u of the SiC single crystal 40. In addition, the surface 30u of the seed crystal 30 has an inclination of approximately 55° with respect to a plane over which stacking faults 44 spread (shown by broken lines in the figure), that is, a plane that is perpendicular to the direction <0001>, meaning that, if an SiC single crystal 40 is grown to a given extent on the seed crystal 30, the stacking faults 44 reach a lateral face 40s of this SiC single crystal 40, and it is therefore possible to suppress the situation where these stacking faults 44 reach the surface 40u of the SiC single crystal 40.

Additionally, as shown in Fig. 4, even if the surface 30u of the seed crystal 30 is not the plane {01-14}, as per the present embodiment, but instead is a plane that is inclined by an off angle α equal to or less than approximately 10° with respect to the plane {01-14}, it is equally possible to suppress the situation where micropipes 42 and stacking faults 44 reach the surface 40u of the SiC single crystal 40 thus grown. Furthermore, it is preferable that the off angle α should be equal to or less than 5°, and more preferably, equal to or less than 3°. In other words, the closer the surface of the seed crystal is to the plane {01-14}, the more feasible it becomes to reliably suppress the situation where micropipes 42 and stacking faults 44 reach the surface 40u of the SiC single crystal 40.

### [Examples]

An SiC single crystal and method for growing same, according to the present invention, will be described specifically by referring to examples.

### Example 1

In Example 1, a 6H-SiC single crystal, in which a (01-14) plane is exposed, was used as the seed crystal 30. Further, with the pressure force within the reaction tube 8 held at 4 Torr, the temperature of the raw material 15 set at approximately 2300°C, and the temperature of the seed crystal 30 set at approximately 2250°C, an SiC single crystal 40 with a diameter of two inches was grown on the seed crystal 30. The rate of growth at this time was 1 mm/h and the thickness of the SiC single crystal was 20 mm.

Upon subjecting the SiC single crystal 40 thus provided to Raman spectrometry analysis, it was established that the whole of the surface was of a 6H type structure. Further, the bulk of the SiC single crystal 40 was sliced into a wafer shape with a thickness of approximately 330 µm, which was then polished with a diamond grindstone such that the upper and reverse faces of the wafer were mirror-finished. As a result, upon visual observation, it was evident that the whole of the surface of this SiC single crystal wafer was homogenous, and that poly-crystallization from the edges thereof and crystal polymorphism had not occurred. Furthermore, upon subjecting the wafer to an etching process using dissolved gallium hydroxide and then evaluating the result, micropipes and stacking faults were not observed at the surface of the wafer.

### Example 2

In Example 2, a 6H-SiC single crystal, in which a plane inclined by 3° in the direction of the plane (0001) with respect to the plane (01-14) is exposed, was used as the seed crystal 30. Further, with the pressure force within the reaction tube 8 held at 4 Torr, the temperature of the raw material 15 set at approximately 2300°C, and the temperature of the seed crystal 30 set at approximately 2170°C, an SiC single crystal 40 with a diameter of two inches was grown as a bulk on the seed crystal 30. The rate of growth at this time was 0.8 mm/h and the thickness of the SiC single crystal was 16 mm. Further, in the same manner as Example 1, when a wafer was fabricated by slicing the bulk of the SiC single crystal 40, this wafer was subjected to an etching process, and the result was evaluated, micropipes and stacking faults were not observed.

### Example 3

In Example 3, a 6H-SiC single crystal, in which a plane inclined by 5° in the direction of the plane (0001) with respect to the plane (01-14) is exposed, was used as the seed crystal 30. Further, with the pressure force within the reaction tube 8 held at 4 Torr, the temperature of the raw material 15 set at approximately 2300°C, and the temperature of the seed crystal 30 set at approximately 2170°C, an SiC single crystal 40 with a diameter of two inches was grown as a bulk on the seed crystal 30. The rate of growth at this time was 0.8 mm/h and the thickness of the SiC single crystal was 16 mm. Further, when a wafer was fabricated by slicing the bulk of the SiC single crystal 40, this wafer was subjected to an etching process, and the result was evaluated, micropipes and stacking faults were not observed.

### Example 4

In Example 4, a 6H-SiC single crystal, in which a plane inclined by 10° in the direction of the plane (0001) with respect to the plane (01-14) is exposed, was used as the seed crystal 30. Further, with the pressure force within the reaction tube 8 held at 4 Torr, the temperature of the raw material 15 set at approximately 2300°C, and the temperature of the seed crystal 30 set at approximately 2170°C, an SiC single crystal 40 with a diameter of two inches was grown as a bulk on the seed crystal 30. The rate of growth at this time was 0.8 mm/h and the thickness of the SiC single crystal was 16 mm. Further, when a wafer was fabricated by slicing the bulk of the SiC single crystal 40, this wafer was subjected to an etching process, and [the result] was evaluated, micropipes and stacking faults were not observed.

### Comparative example 1

For the purposes of comparison with the above-described Examples, a 6H-SiC single crystal, in which the plane (0001) was exposed, was used as the seed crystal. Further, with the pressure force within the reaction tube held at 4 Torr, the temperature of the raw material set at approximately 2300 °C, and the temperature of the seed crystal set at approximately 2170°C, an SiC single crystal with a diameter of two inches was grown as a bulk on the seed crystal. The rate of growth at this time was 0.6 mm/h and the thickness of the SiC single crystal was 12 mm. Further, Further, when a wafer was fabricated by slicing the bulk of the SiC single crystal 40, this wafer was subjected to an etching process, and [the result] was evaluated, stacking faults were not observed, but micropipes were observed at a rate of approximately 300 / cm².

### Comparative example 2

In Comparative example 2, a 6H - SiC single crystal, in which a plane (0-101) was exposed, was used as the seed crystal. Further, with the pressure force within the reaction tube held at 4 Torr, the temperature of the raw material set at approximately 2300°C, and the temperature of the seed crystal set at approximately 2170°C, an SiC single crystal with a diameter of two inches was grown as a bulk on the seed crystal. The rate of growth at this time was 0.8 mm/h and the thickness of the SiC single crystal was 16mm. Further, when a wafer was fabricated by slicing the bulk of the SiC single crystal 40, this wafer was subjected to an etching process, and the result was evaluated, micropipes were not observed, but stacking faults were observed at a rate of 1000 / cm².

### Comparative example 3

In Comparative example 3, a 6H - SiC single crystal, in which a plane (11-20) was exposed, was used as the seed crystal. Further, with the pressure force within the reaction tube held at 4 Torr, the temperature of the raw material set at approximately 2300°C, and the temperature of the seed crystal set at approximately 2170°C, an SiC single crystal with a diameter of two inches was grown as a bulk on the seed crystal. The rate of growth at this time was 0.7 mm/h and the thickness of the SiC single crystal was 14 mm. Further, when a wafer was fabricated by slicing the bulk of the SiC single crystal 40, this wafer was subjected to an etching process, and [the result] was evaluated, micropipes were not observed, but stacking faults were observed at a rate of 500 / cm².

Hereinabove, the invention made by the present inventors has been described specifically on the basis of embodiments. However, the present invention is not limited by the embodiments described above. For example, the crystal growing device for growing an SiC single crystal is not limited to the device illustrated in Fig. 1, it being possible to use a variety of other devices.

### INDUSTRIAL APPLICABILITY

As described hereinabove, the SiC single crystal according to the present invention has barely any micropipes or stacking faults exposed at the surface thereof, and, by means of the SiC single crystal growth method according to the present invention, it is possible to reduce the micropipes and stacking faults exposed at the surface of an SiC single crystal.

## Claims

1. A method for growing a 6H-poly-type SiC single crystal, **characterized in that** a 6H-poly-type SiC single crystal is grown, to a height for which micropipes and stacking faults reach a lateral face of said 6H-poly-type SiC single crystal but said micropipes and said stacking faults do not reach the surface thereof, on a seed crystal composed from an SiC single crystal in which a plane inclined by an off angle α equal to or less than approximately 10° with respect to the plane {01-14} is exposed.

2. The method for growing an SiC single crystal according to claim 1, **characterized in that** said off angle α is equal to or less than 5°.

3. The method for growing an SiC single crystal according to claim 1, **characterized in that** said off angle α is equal to or less than 3°.

4. A method for growing an SiC single crystal according to claim 1 comprising the step of sublimating SiC raw material powder in a graphite crucible so as to re-crystallize a 6H-poly-type SiC single crystal on said seed crystal which has been placed in said crucible.

5. The method for growing an SiC single crystal according to claim 1, **characterized in that** said 6H-poly-type SiC single crystal is grown such that the height thereof is equal to or greater than L x tan 54.74°.

6. A 6H-poly-type SiC single crystal, obtainable by the method as defined in any of claims 1 to 5.

## Patentansprüche

1. Wachstumsverfahren für einen 6H-Polytyp-SiC-Einkristall, **dadurch gekennzeichnet, daß** ein 6H-Polytyp-SiC-Einkristall bis zu einer Höhe, bei der Mikroröhren und Stapelfehler eine Seitenfläche des 6H-Polytyp-SiC-Einkristalls erreichen, aber die Mikroröhren und die Stapelfehler nicht dessen Oberfläche erreichen, auf einem Impfkristall wächst, der aus einem SiC-Einkristall aufgebaut ist, in dem eine Ebene mit einem Neigungswinkel α, der gleich oder weniger als etwa 10° beträgt, bezüglich der Ebene {01-14} freigelegt ist.

2. Wachstumsverfahren für einen SiC-Einkristall gemäß Anspruch 1, **dadurch gekennzeichnet, daß** der Winkel α gleich oder weniger als 5° beträgt.

3. Wachstumsverfahren für einen SiC-Einkristall gemäß Anspruch 1, **dadurch gekennzeichnet, daß** der Winkel α gleich oder weniger als 3° beträgt.

4. Wachstumsverfahren für einen SiC-Einkristall gemäß Anspruch 1, welches den Schritt des Sublimierens eines SiC-Rohmaterialpulvers in einem Graphittiegel umfaßt, um den 6H-Polytyp-SiC-Einkristall auf dem Impfkristall zu kristallisieren, der in den Tiegel gelegt wurde.

5. Wachstumsverfahren für einen SiC-Einkristall gemäß Anspruch 1, **dadurch gekennzeichnet, daß** der 6H-Polytyp-SiC-Einkristall so lange wächst, bis seine Höhe gleich oder größer als L x tan 54,74° beträgt.

6. 6H-Polytyp-SiC-Einkristall erhältlich durch das Verfahren, wie es in einem der Ansprüche 1 bis 5 definiert ist.

## Revendications

1. Procédé de croissance d'un monocristal en SiC de type poly-6H, **caractérisé en ce que** le monocristal en SiC de type poly-6H a subi une croissance jusqu'à une hauteur pour laquelle les micro-conduits et les défauts d'empilement atteignent une face latérale dudit monocristal en SiC de type poly-6H, mais lesdits micro-conduits et lesdits défauts d'empilement n'atteignent pas sa surface, sur un germe cristallin composé d'un monocristal en SiC dans lequel un plan incliné d'un angle de décalage α égal ou inférieur à environ 10° par rapport au plan {01-14} est exposé.

2. Procédé de croissance d'un monocristal en SiC selon la revendication 1, **caractérisé en ce que** ledit angle de décalage α est égal ou inférieur à 5°.

3. Procédé de croissance d'un monocristal en SiC selon la revendication 1, **caractérisé en ce que** ledit angle de décalage α est égal ou inférieur à 3°.

4. Procédé de croissance d'un monocristal en SiC selon la revendication 1, comprenant l'étape consistant à sublimer une poudre de matériau brut de SiC dans un creuset en graphite de façon à recristalliser un monocristal en SiC de type poly-6H sur ledit germe cristallin qui a été placé dans ledit creuset.

5. Procédé de croissance d'un monocristal en SiC selon la revendication 1, **caractérisé en ce que** ledit monocristal en SiC de type poly-6H a subi une croissance de telle sorte que sa hauteur soit égale ou supérieure à L x tg 54,74°.

6. Monocristal en SiC de type poly-6H pouvant être obtenu par le procédé défini dans l'une quelconque des revendications 1 à 5.
